# EUROPEAN PATENT APPLICATION

(11) **EP 4 693 256 A1**
(43) Date of publication of application: **11.02.2026**
(21) Application number: 24792995.3
(22) Date of filing: 17.04.2024
(51) Int. Cl.: G09F 3/20, H05K 5/02, H01R 12/77, G09F 9/30, G09G 3/30

(54) **ELECTRONIC SHELF LABEL AND METHOD FOR DRIVING ELECTRONIC SHELF LABEL**

(30) Priority: 19.04.2023 KR 20230051518
(71) Applicant: SOLUM CO., LTD., Gyeonggi-do 16914 (KR)
(72) Inventor: LEE, Seo Jin, Yongin-si, Gyeonggi-do 16914 (KR)
(74) Representative: South, Nicholas Geoffrey
(86) International application number: PCT/KR2024/005134
(87) International publication number: WO 2024/219810

(57) **Abstract**

An embodiment provides an electronic shelf label comprising: a first window; a main case which is coupled to the rear surface of the first window; a first display module which is provided in a first inner space formed between the first window and the main case to display product information; a first printed circuit board which is provided in the first inner space and electrically connected to the first display module; a second window which is coupled to a rear surface of the main case; a second display module which is provided in a second inner space formed between the second window and the main case to display product information; a second printed circuit board which is provided in the second inner space and electrically connected to the second display module; and a battery which is provided to be inserted into the main case.

## Description

### [Technical Field]

The present disclosure relates to an electronic shelf label and a method of operating the electronic shelf label.

### [Background Art]

Electronic labels are increasingly being used in applications such as displaying product information on products displayed in stores. Electronic labels, also known as electronic shelf labels or electronic tags, are connected to a server via a gateway, receive product information, and display the received product information on an electronic paper display. Electronic paper displays are increasingly being used due to their low-power operation, which allows for extended battery life, and the ability to change display information via a communications network, which reduces store management labor costs.

When a new product is placed on a shelf, a process is required to assign the new product to an electronic shelf label such that the electronic shelf label displays the information on the new product. Typically, a store manager reads a barcode attached to an electronic label with a terminal, then reads the product barcode and transmits the same to a server. The server then assigns the electronic shelf label to the product, registers the same in a database, and transmits relevant information about the product to the electronic shelf label to change the display.

An electronic shelf label includes a display module that displays product information, a printed circuit board (PCB) containing an IC chip that operates the display module, a battery that supplies power to the PCB, and a housing for protecting these key components. The housing may include a transparent window covering the display module and a main case that is combined with the window to form an internal space for housing the display module, the PCB, and the battery.

Meanwhile, dual-sided electronic shelf labels having display modules provided on the front and rear surfaces thereof to display product-related information on both sides thereof can provide various customer experiences. Research is underway to develop a structure for such double-sided labels that offers enhanced durability and a slim design that meets the demands of consumers seeking esthetics.

### [Disclosure]

### [Technical Problem]

According to various embodiments of the present disclosure, a double-sided electronic shelf label having improved durability and a slim design and a method of operating the electronic shelf label are provided.

According to various embodiments of the present disclosure, a double-sided electronic shelf label having a first display module and a second display module that can be independently controlled and a method of operating the electronic shelf label are provided.

### [Technical Solution]

An embodiment provides an electronic shelf label including a first window, a main case coupled to a rear surface of the first window, a first display module provided in a first internal space formed between the first window and the main case to display product information, a first printed circuit board provided in the first internal space and electrically connected to the first display module, a second window coupled to a rear surface of the main case, a second display module provided in a second internal space formed between the second window and the main case to display product information, a second printed circuit board provided in the second internal space and electrically connected to the second display module, and a battery inserted and provided within the main case.

In another aspect, the main case may include an insertion hole formed in a side surface and a battery fastening recess extending from the insertion hole into the interior of the main case.

In another aspect, the battery is inserted into the insertion hole and provided within the battery fastening recess.

In another aspect, a battery fixing portion for fixing the battery may be formed within the battery fastening recess.

In another aspect, the side surface of the battery may have a curved shape.

In another aspect, the battery fixing portion may have a curved shape corresponding to the curved shape of the side surface of the battery.

In another aspect, the battery fixing portion may include a first protruding curved portion that contacts the left side of the battery and a second protruding curved portion that contacts the right side of the battery.

In another aspect, the battery fixing portion may include a clamp-shaped curved portion provided at a position facing the insertion hole within the battery fastening recess.

In another aspect, the main case may include a plate extending horizontally, an upper outer wall protruding upward from an edge region of the upper surface of the plate to form the first internal space, and a lower outer wall protruding downward from an edge region of the lower surface of the plate to form the second internal space.

In another aspect, a connecting hole may be formed in the main case to connect the first internal space and the second internal space.

In another aspect, the electronic shelf label may further include a connector connecting the first printed circuit board and the second printed circuit board.

In another aspect, the connector may be formed in the main case and connect the first printed circuit board and the second printed circuit board through the connecting hole connecting the first internal space and the second internal space.

In another aspect, the electronic shelf label may further include a first reinforcing plate provided between the first display module and the first printed circuit board, and a second reinforcing plate provided between the second display module and the second printed circuit board.

In another aspect, the area of the first reinforcing plate may be larger than the area of the first display module, and the area of the second reinforcing plate may be larger than the area of the second display module.

In another aspect, at least one fixing recess may be formed at a portion of the outer side surface of the main case, and a fastening member formed to be coupled to an external fixing member may be provided in each fixing recess.

In another aspect, hanging holes formed to be coupled to external strings may be provided at corners of the main case.

An embodiment provides
a method of operating an electronic shelf label comprising a first display module exposed on the front, a first printed circuit board electrically connected to the first display module, a second display module exposed on the rear, and a second printed circuit board electrically connected to the second display module, the method including receiving a first user input, operating the first display module according to the first user input, receiving a second user input, and operating the second display module according to the second user input.

In another aspect, the first user input and the second user input may be inputs from the same first user, and the first user input and the second user input may be different from each other.

In another aspect, the first user input may be input from a first user, and the second user input may be input from a second user different from the first user.

In another aspect, reception of user input for operating the first display module from the second user may be blocked when the first user input for operating the first display module from the first user is received, and reception of user input for operating the second display module from the first user may be blocked when the second user input for operating the second display module from the second user is received.

### [Advantageous Effects]

According to various embodiments of the present disclosure, it is possible to provide a double-sided electronic shelf label and a method of operating the electronic shelf label having improved durability and a slim design vided by providing a first display module and a first printed circuit board in a first internal space separated from a second internal space based on a main case and providing a second display module and a second printed circuit board in the second internal space.

According to various embodiments of the present disclosure, it is possible to provide a double-sided electronic shelf label having a first display module and a second display module that can be independently controlled by respectively receiving user inputs for the first display module and the second display module, and a method of operating the electronic shelf label.

### [Description of Drawings]

FIG. 1 illustrates an exemplary configuration of an electronic shelf label system that displays product-related information according to an embodiment.
FIG. 2 is a perspective view illustrating an exemplary configuration of an electronic shelf label according to an embodiment.
FIG. 3 is a front view illustrating an exemplary configuration of the electronic shelf label according to an embodiment.
FIG. 4 is a rear view illustrating an exemplary configuration of the electronic shelf label according to an embodiment.
FIG. 5 is a block diagram illustrating an exemplary configuration of a server according to an embodiment.
FIG. 6 is a block diagram illustrating an exemplary configuration of a computing device according to an embodiment.
FIG. 7 is an exploded view illustrating an exemplary configuration of the electronic shelf label according to an embodiment.
FIG. 8 is a cross-sectional view taken along line A-A' in FIG. 2.
FIG. 9 illustrates a front structure of a battery fixing portion according to an embodiment.
FIG. 10 illustrates a rear structure of the battery holder according to an embodiment.
FIG. 11 illustrates a structure of a battery holder according to another embodiment.
FIG. 12 illustrates a state in which strings are coupled to the electronic shelf label according to an embodiment.
FIG. 13 illustrates a state in which strings are coupled to the electronic shelf label according to another embodiment.
FIG. 14 illustrates a configuration of a hanging hole formed in the electronic shelf label according to an embodiment.
FIG. 15 is a flowchart illustrating a method of operating an electronic shelf label according to an embodiment.

### [Mode for Invention]

The present disclosure is capable of various modifications and embodiments. Therefore, specific embodiments are illustrated in the drawings and described in detail in the detailed description. The effects and features of the present disclosure, and the methods for achieving the same will become clearer with reference to the embodiments described in detail below together with the drawings. However, the present disclosure is not limited to the embodiments disclosed below and can be implemented in various forms. In the following embodiments, terms such as "first" and "second" are not used in a limiting sense but are used for the purpose of distinguishing one component from another. Furthermore, the singular expression includes plural expressions unless the context clearly indicates otherwise. Furthermore, terms such as "include" and "comprise" indicate the presence of a feature or a component described in the specification, and do not preemptively exclude the possibility of one or more other features or components being added. Furthermore, the sizes of components in the drawings may be exaggerated or reduced for convenience of description. For example, the size and thickness of each component shown in the drawings are arbitrarily shown for convenience of description, and thus the present disclosure is not necessarily limited to what is shown.

Hereinafter, embodiments of the present disclosure will be described in detail with reference to the attached drawings. When describing with reference to the drawings, identical or corresponding components are given the same reference numerals and redundant descriptions thereof will be omitted.

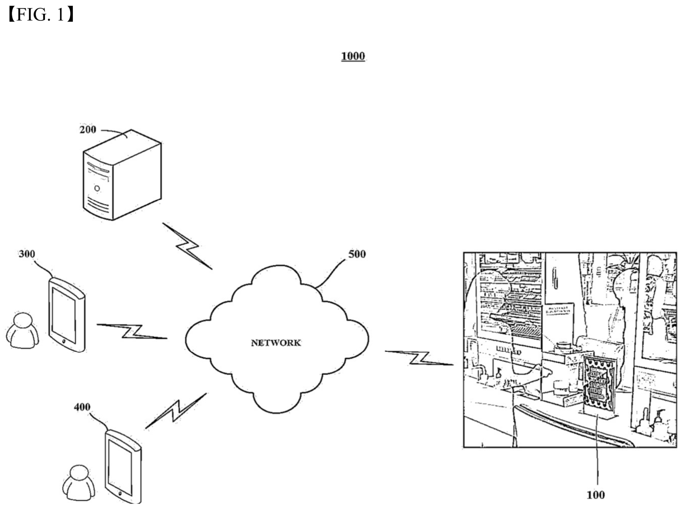

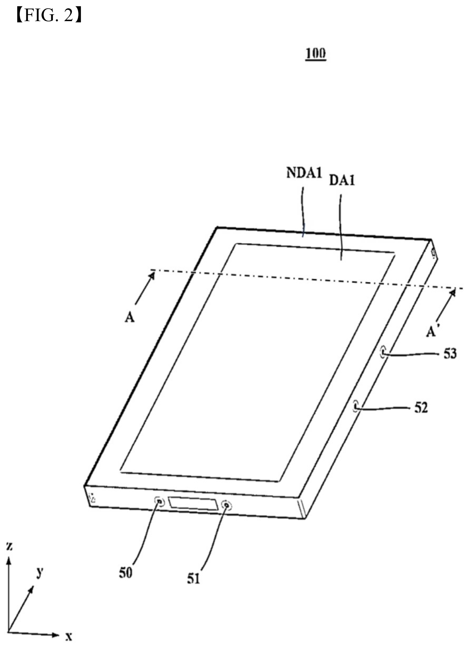

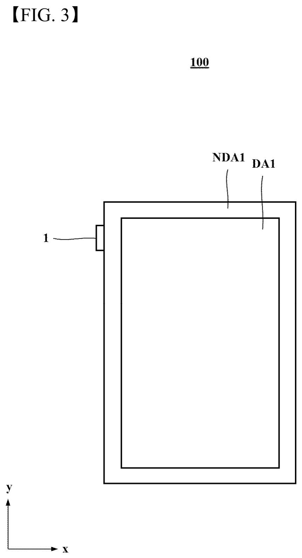

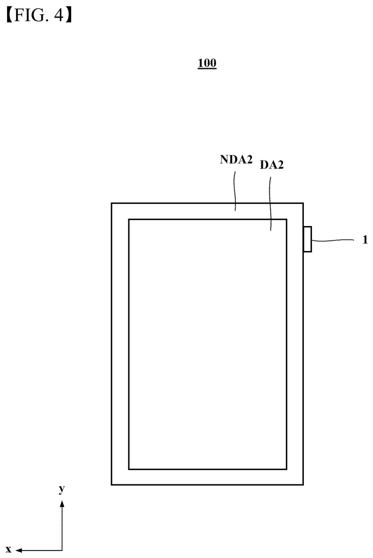

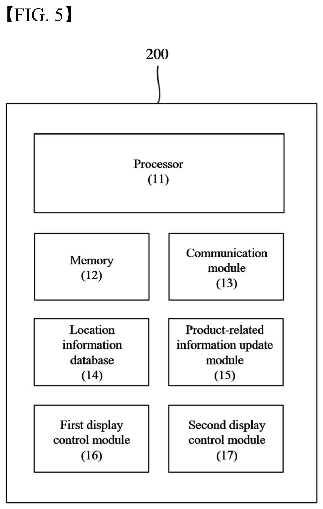

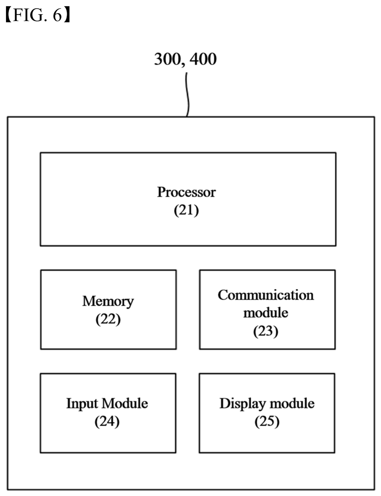

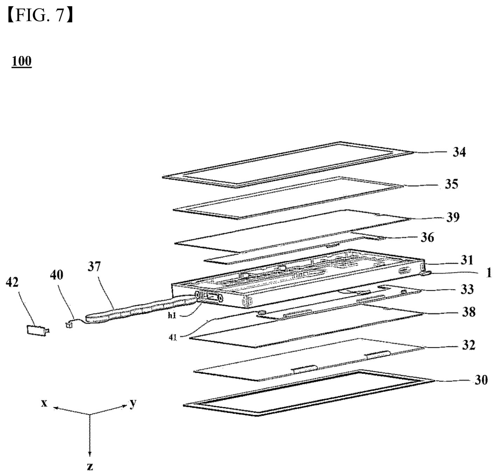

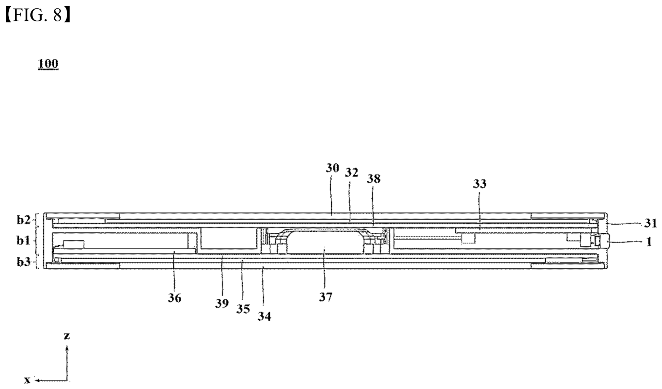

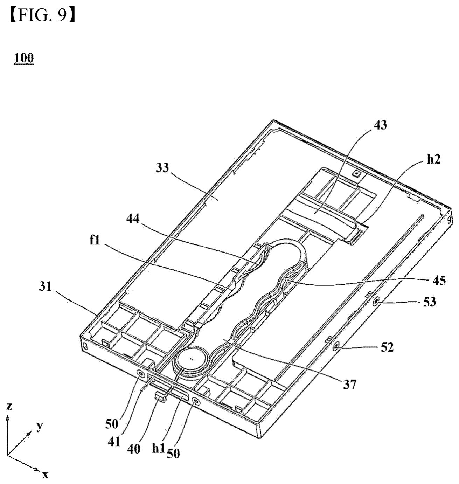

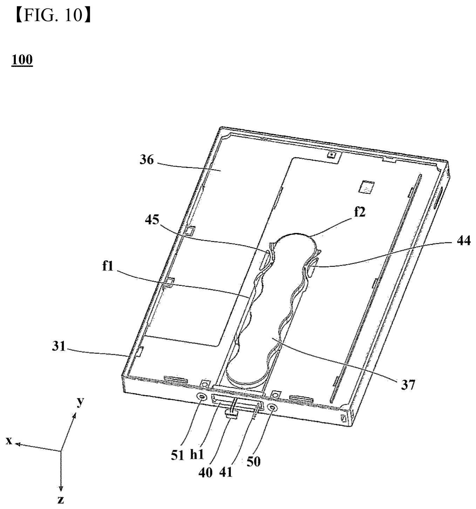

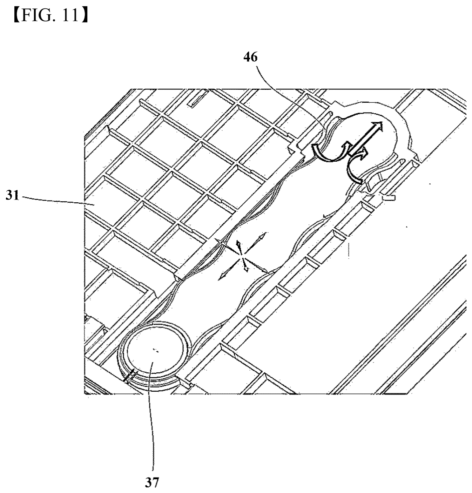

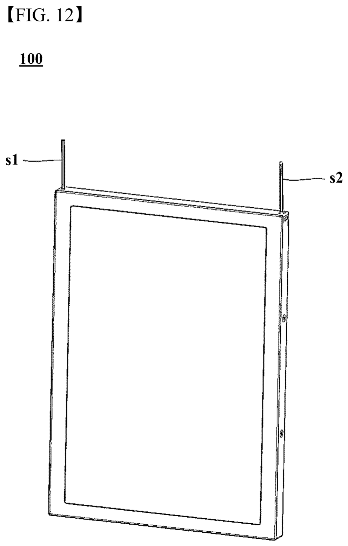

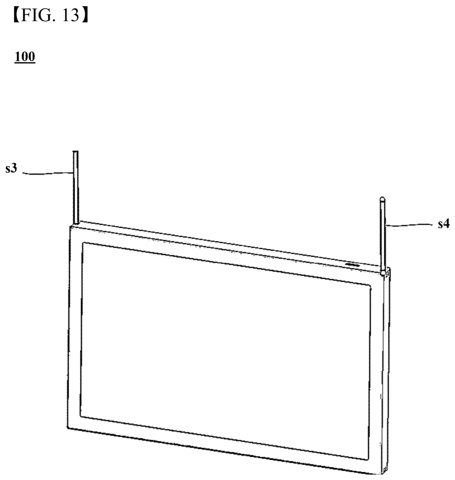

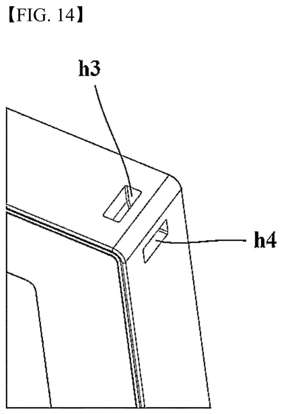

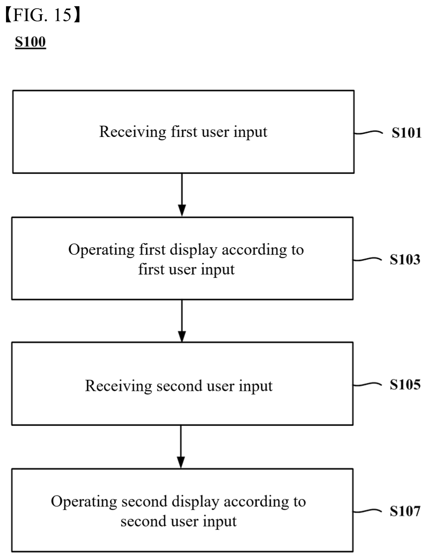

FIG. 1 illustrates an exemplary configuration of an electronic shelf label system 1000 that displays product-related information according to an embodiment. FIG. 2 is a perspective view illustrating an exemplary configuration of an electronic shelf label 100 according to an embodiment. FIG. 3 is a front view illustrating an exemplary configuration of the electronic shelf label 100 according to an embodiment. FIG. 4 is a rear view illustrating an exemplary configuration of the electronic shelf label 100 according to an embodiment. FIG. 5 is a block diagram illustrating an exemplary configuration of a server 200 according to an embodiment. FIG. 6 is a block diagram illustrating an exemplary configuration of a computing device 300, 400 according to an embodiment. FIG. 7 is an exploded view illustrating an exemplary configuration of the electronic shelf label 100 according to an embodiment. FIG. 8 is a cross-sectional view taken along line A-A' in FIG. 2. FIG. 9 illustrates a front structure of battery fixing portions 44 and 45 according to an embodiment. FIG. 10 illustrates a rear structure of the battery holder 44 and 45 according to an embodiment. FIG. 11 illustrates a structure of a battery holder 46 according to another embodiment. FIG. 12 illustrates a state in which strings s1 and s2 are coupled to the electronic shelf label 100 according to an embodiment. FIG. 13 illustrates a state in which strings s3 and s4 are coupled to the electronic shelf label 100 according to another embodiment. FIG. 14 illustrates a configuration of hanging holes h3 and h4 formed in the electronic shelf label 100 according to an embodiment. FIG. 15 is a flowchart illustrating a method of operating an electronic shelf label according to an embodiment.

### - System 1000

Referring to FIG. 1, the system 1000 may include an electronic shelf label 100, a server 200, and computing devices 300 and 400. The computing devices 300 and 400 may include portable user terminals.

The electronic shelf label 100 may be linked to the server 200, and product-related information displayed on the electronic shelf label 100 may be updated by the server 200. Data regarding the updated product-related information is transmitted from the server 200 to the electronic shelf label 100, and the electronic shelf label 100 may display the updated product-related information. In this case, the server 200 may update product-related information based on user input via the computing devices 300 and 400.

For example, a plurality of electronic shelf labels 100 and a plurality of products may be provided on a shelf in a store. Each product may be assigned to each electronic shelf label 100. A first product may be assigned to any first electronic shelf label among the plurality of electronic shelf labels 100, and a second product different from the first product may be assigned to any second electronic shelf label. The first electronic shelf label and the first product may be provided adjacent to each other, and the second electronic shelf label and the second product may be provided adjacent to each other.

The server 200 may update information related to the products assigned to the electronic shelf labels 100. The server 200 may collectively update the information related to the products and transmit the updated information related to the products to the electronic shelf labels 100.

For example, the server 200 may update information related to any first product among the plurality of products and transmit the updated information related to the first product to the first electronic shelf label to which the first product is assigned. Furthermore, the server 200 may update information related to any second product among the plurality of products and transmit the updated information related to the second product to the second electronic shelf label to which the second product is assigned.

The electronic shelf label 100, the server 200, and the computing devices 300 and 400 may be connected to each other through a network 500. Here, the network 500 according to the embodiment may refer to a connection structure that enables information exchange between nodes, such as the electronic shelf label 100, the server 200, and the computing devices 300 and 400. For example, the network 500 may include, but is not limited to, a 3rd Generation Partnership Project (3GPP) network, a Long Term Evolution (LTE) network, a World Interoperability for Microwave Access (WIMAX) network, the Internet, a local area network (LAN), a wireless LAN, a wide area network (WAN), a personal area network (PAN), a Bluetooth network, a satellite broadcasting network, an analog broadcasting network, a digital multimedia broadcasting (DMB) network, etc.

The electronic shelf label 100 may be wirelessly connected to the server 200 via a separate gateway (not shown). However, the present disclosure is not limited thereto, and the electronic shelf label 100 may be connected to the computing devices 300 and 400 via wireless communication. For example, the electronic shelf label 100 may be paired to the computing devices 300 and 400 based on the Bluetooth function.

The electronic shelf label 100 may be an electronic device mounted on a shelf to display information related to a product displayed on the shelf. For example, the electronic shelf label 100 may display product-related information such as a Korean product name, an English product name, a country of origin, a product price, raw materials, and weight/calories. However, the present disclosure is not limited thereto, and information related to a product may further include advertising videos for the product, promotional information for the product, etc.

The electronic shelf label 100 may include an electronic paper display (EPD), which maintains a product information display state even when power is not supplied. Due to bistability, which allows the electronic paper display to maintain the display state for a long period of time even when power is interrupted, the electronic paper display is suitable for the electronic shelf label 100 that requires reduced power consumption. Known electronic paper displays include a twist ball type using a hemispherical twist ball charged with electrostatic charge, an electrophoretic display utilizing electrophoresis and microcapsules, a cholesterol liquid crystal display using cholesterol liquid crystals, etc.

However, the present disclosure is not limited thereto, and the electronic shelf label 100 may include any one of a liquid crystal display (LCD), a thin film transistor-liquid crystal display (TFT LCD), an organic light-emitting diode (OLED), a flexible display, and a 3D display.

Referring to FIG. 2 to FIG. 4, the electronic shelf label 100 may have display areas DA1 and DA2 on the front and rear sides thereof, which display product-related information displayed on a display module.

For example, referring to FIG. 2 and FIG. 3, a first display area DA1 and a first non-display area NDA1 surrounding the first display area DA1 may be provided on the front side of the electronic shelf label 100. Here, the first display area DA1 may be an area that displays product-related information displayed on a first display module included within the electronic shelf label 100.

Referring to FIG. 4, a second display area DA2 and a second non-display area NDA2 surrounding the second display area DA2 may be provided on the rear side of the electronic shelf label 100. Here, the second display area DA2 may be an area that displays product-related information displayed on a second display module included within the electronic shelf label 100.

A button 1 may be provided on a portion of the side surface of the electronic shelf label 100. However, the present disclosure is not limited thereto, and the button 1 may be provided on the front or rear side of the electronic shelf label 100.

A pairing signal may be transmitted from the electronic shelf label 100 to the computing devices 300 and 400 based on user input via the button 1. Accordingly, the electronic shelf label 100 may be paired with the computing devices 300 and 400 using Bluetooth.

For example, when a user presses the button 1, a pairing signal is transmitted from the electronic shelf label 100 to the computing device 300 or 400, and the electronic shelf label 100 can be paired with the computing device 300 or 400 based on the Bluetooth function.

A plurality of fastening members 50, 51, 52, and 53 formed to be coupled to external fixing members may be provided on portions of the outer surface of the electronic shelf label 100.

For example, a first fastening member 50 and a second fastening member 51 may be provided on the lower surface of the electronic shelf label 100. Additionally, a third fastening member 52 and a fourth fastening member 53 may be provided on a side surface of the electronic shelf label 100. Here, each of the plurality of fastening members 50, 51, 52, and 53 may include an insert that can be fastened to a bolt-shaped fastening member.

The server 200 may update information related to a product assigned to the electronic shelf label 100 provided on a shelf and transmit the updated product-related information to the electronic shelf label 100. In this case, the server 200 may update the product-related information based on user input received via the computing devices 300 and 400.

Specifically, to update information related to the product assigned to the electronic shelf label 100, the server 200 may exchange necessary data with the electronic shelf label 100 and the computing device 300 or 400. Accordingly, the server 200 may provide an environment necessary for updating the product-related information.

For example, the server 200 may provide an environment in which product-related information can be updated using the computing devices 300 and 400 (e.g., a portable user terminal type computing device, a desktop type computing device, etc.). The server 200 may include an application program, data and/or instructions for operating a product-related information update application, and may transmit data based thereon to the computing devices 300 and 400.

Additionally, the server 200 may provide a license key to the computing devices 300 and 400. For example, the server 200 may provide an editing license key for granting the computing devices 300 and 400 the authority to update product-related information. For example, customers or employees of a store may receive a product-related information update service by using the computing devices 300 and 400 that has received the editing license key.

Referring to FIG. 5, the server 200 may be implemented as a computing device that includes at least one processor 11 for data processing, a memory 12 storing application programs, data, and/or instructions, at least one communication module 13 for data exchange with external devices, a location information database 14 storing location information of the electronic shelf label 100, a product-related information update module 15 for updating product-related information, a first display control module 16 for controlling the operation of the first display module exposed on the front side of the electronic shelf label 100, and a second display control module 17 for controlling the operation of the second display module exposed on the rear side of the electronic shelf label 100.

The processor 11 may control the overall operation of components included in the server 200 to provide an environment in which a product-related information update application can operate on the computing devices 300 and 400.

The processor 11 may be a system-on-chip (SOC) including a central processing unit (CPU) and/or a graphics processing unit (GPU), and may execute an operating system (OS) and/or application programs stored in the memory 12.

In addition, the processor 11 may internally communicate with each component included in the server 200 via a system bus, and may include one or more predetermined bus structures, including a local bus.

Additionally, the processor 11 may be implemented using at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

The memory 12 may store one or more of an operating system (OS), various application programs, data, and instructions for providing an environment necessary to perform a method of updating product-related information.

Furthermore, the memory 12 may include a program area and a data area. Here, the program area according to an embodiment may be linked between the operating system (OS) that boots the server 200 and functional elements, and data generated according to the use of the server 200 may be stored in the data area.

In an embodiment, the memory 12 may be various storage devices such as a ROM, a RAM, an EPROM, a flash drive, and a hard drive or may be a web storage that performs a storage function over the Internet. Furthermore, the memory 12 may be a storage medium that is removable from the server 200.

The communication module 13 may include various types of communication devices that enable the server 200 to transmit/receive data to/from external devices. The server 200 can transmit data based on an application program, data, and/or instructions for the product-related information update application to the computing devices 300 and 400 via the communication module 13.

The location information database 14 may store location information of the electronic shelf label 100. A plurality of electronic shelf labels 100 may be provided on a shelf to correspond to a plurality of products. These electronic shelf labels 100 may be placed at specific locations on the shelf, and specific location information of the plurality of electronic shelf labels 100 with respect to the shelf may be stored in the location information database 14.

For example, among the plurality of electronic shelf labels 100, a first electronic shelf label may be provided on the second row, third column of the first shelf provided in zone A among a plurality of zones. In this case, the location information of the first electronic shelf label, "the second row, third column of the first shelf in zone A," may be stored in the location information database 14 as the location information of the first electronic shelf label in association with unique identification number of the first electronic shelf label.

The product-related information update module 15 may update product-related information displayed on the electronic shelf label 100. For example, the product-related information update module 16 may control the electronic shelf label 100 such that product-related information displayed on the electronic shelf label 100 is periodically updated according to a product-related information update rule stored in the memory 12. The product-related information update rule stored in the memory 12 may be preset by the user and constantly modified. In this case, the product-related information update module 15 may control the electronic shelf label 100 through the first display control module 16 and the second display control module 17 as will be described later.

However, the present disclosure is not limited thereto, and the product-related information update module 16 may also control the electronic shelf label 100 such that product-related information displayed on the electronic shelf label 100 is updated according to user input for editing the product-related information.

The first display control module 16 may control the operation of the first display module by receiving a signal for controlling the operation of the first display module from the product-related information update module 15.

For example, if a signal for displaying first product-related information on the first display module is received from the product-related information update module 15, the first display control module 16 may control the first display module such that the first product-related information is displayed on the first display module.

The second display control module 17 may control the operation of the second display module by receiving a signal for controlling the operation of the second display module from the product-related information update module 15.

For example, if a signal for displaying second product-related information on the second display module is received from the product-related information update module 15, the second display control module 17 may control the second display module such that the second product-related information is displayed on the second display module.

In the above description, the server 200 according to an embodiment performs the functional operations as described above. However, at least some functional operations performed by the server 200 may be performed by an external device (e.g., the computing devices 300 and 400), and at least some functional operations performed by the external device may be further performed by the server 200 according to various embodiments.

The computing devices 300 and 400 may be devices in which the product-related information update application is installed. The computing devices 300 and 400 may include a portable user terminal. The computing devices 300 and 400 may be divided into a first computing device 300 and a second computing device 400 according to the user.

For example, the user of the first computing device 300 may be a store employee, and the user of the second computing device 400 may be a store customer. The first computing device 300 and the second computing device 400 may have substantially the same structure.

The computing devices 300 and 400 may be implemented as, for example, a computer or a portable terminal that can connect to the server 200 via a network 500. Here, the computer may include, for example, a notebook, desktop, laptop equipped and a VR HMD (for example, HTC VIVE, Oculus Rift, GearVR, DayDream, PSVR, etc.) with a web browser, etc. Here, the VR HMD includes all of VR HMD for PCs (for example, HTC VIVE, Oculus Rift, FOVE, Deepon, etc.), VR HMD for mobiles (for example, GearVR, DayDream, Storm Magic, Google Cardboard, etc.), and stand-alone models (for example, Deepon, PICO, etc.) implemented independently of VR HMD for consoles (for example, PSVR). The portable terminal is, for example, a wireless communication device that ensures portability and mobility, and may include various devices equipped with communication modules such as Bluetooth (Bluetooth Low Energy (BLE)), NFC, RFID, ultrasonic, infrared, Wi-Fi, and Li-Fi, as well as a smartphone, a tablet, and a wearable device.

Referring to FIG. 6, each of the computing devices 300 and 400 may include a processor 21, a memory 22, a communication module 23, an input module 24, and a display module 25. Various components included in the computing devices 300 and 400 may be designed to be incorporated within the housings of the computing devices 300 and 400.

In an embodiment, the processor 21 may control the overall operation of the components included in the computing devices 300 and 400 via a product-related information update application stored in the memory 22 to provide an environment for updating product-related information.

For example, the processor 21 may control the operations of the communication module 23 and the input module 24 such that a signal based on user input received through the input module 24 can be transmitted to the electronic shelf label 100 through the communication module 23.

The processor 21 may include a central processing unit (CPU) and/or a graphics processing unit (GPU). Additionally, the processor 21 may include at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

The memory 22 may store instructions and data that can be used to create a product-related information update environment. A product-related information update application may be stored in the memory 22. The product-related information update application may provide various types of user interfaces for providing a product-related information update environment.

The memory 22 may include at least one non-transitory computer-readable storage medium and temporary computer-readable storage medium. For example, the memory 22 may be a variety of storage devices such as a ROM, an EPROM, a flash drive, and a hard drive. In addition, the memory 22 may include a web storage that performs a data storage function on the Internet.

The communication module 23 may include various types of communication devices that enable data transmission/reception to/from external devices. For example, the communication module 23 may transmit/receive data to/from the electronic shelf label 100 and/or the server 200 via a wireless network.

The communication module 23 may wirelessly transmit/receive data to/from at least one of a base station, an external terminal, or an arbitrary server over a mobile communication network established through a communication device capable of performing technical standards or communication methods for mobile communication (e.g., Long Term Evolution (LTE), Long Term Evolution-Advanced (LTE-A), 5G NR (New Radio), or Wi-Fi) or short-range communication methods.

Furthermore, the communication module 23 may be configured to transmit/receive data to/from an external electronic device via Bluetooth. For example, the communication module 23 may receive a pairing signal from the electronic shelf label 100 and pair with the electronic shelf label 100 via Bluetooth.

The input module 24 may be configured to receive various types of user input from the users using the computing devices 300 and 400. For example, the input module 24 may include a touch screen for receiving a user touch input. If the input module 24 is implemented as a touch screen, the input module 24 may be formed integrally with the display module 25. However, the present disclosure is not limited thereto, and the input module 24 may further include a keyboard capable of receiving user input in the form of characters.

The display module 25 may display the product-related information update application stored in the memory 22. For example, the display module 25 may include a display device that displays various types of user interface (UI) images for providing a product-related information update environment.

The display module 25 may include any one of a liquid crystal display (LCD), a thin film transistor-liquid crystal display (TFT LCD), an organic light-emitting diode (OLED), a flexible display, and a 3D display.

### - Structure of Electronic Shelf Label 100

Referring to FIG. 7 and FIG. 8, the electronic shelf label 100 may include a first window 30, a main case 31 coupled to the rear surface of the first window 30, a first display module 32 provided in a first internal space formed between the first window 30 and the main case 31 to display product information, a first printed circuit board 33 provided in the first internal space and electrically connected to the first display module 32, a second window 34 coupled to the rear surface of the main case 31, a second display module 35 provided in a second internal space formed between the second window 34 and the main case 31 to display product information, a second printed circuit board 36 provided in the second internal space and electrically connected to the second display module 35, and a battery 37 provided to be inserted into the main case 31. Here, the front surface of the electronic shelf label 100 refers to the surface in the z-axis direction, and the rear surface thereof refers to the surface in the -z-axis direction.

The first internal space and the second internal space may be separated from each other by the main case 31, and the first display module 32 and the first printed circuit board 33 are provided in the first internal space and the second display module 35 and the second printed circuit board 36 are provided in the second internal space, thereby enabling the electronic shelf label 100 to be manufactured with a slim design.

The first window 30 may have a flat shape including front and rear surfaces. The first window 30 may externally expose product-related information displayed by the first display module 32 through the front surface. Specifically, the first window 30 may be formed of a glass material and may transmit image information output from the first display module 32.

The first window 30 may cover the entire front surface of the first display module 32. For example, the area of the front surface of the first window 30 may be greater than the area of the front surface of the first display module 32. Furthermore, for example, the shape and size of the first display area DA1 in FIG. 2 may correspond to the shape and size of the area where image information of the first display module 32 is output.

The main case 31 may be coupled to the rear surface of the first window 30 to form the first internal space in which the first display module 32 and the first printed circuit board 33 are provided. Furthermore, the main case 31 may be coupled to the front surface of the second window 34 to form the second internal space in which the second display module 35 and the second printed circuit board 36 are provided.

The first internal space and the second internal space may be spatially separated spaces. Specifically, the first internal space and the second internal space may be spatially separated by a plate b1 formed in the central portion of the main case 31. The first internal space may be provided above the plate b1, and the second internal space may be provided below the plate b1.

For example, referring to FIG. 8, the main case 31 may include the plate b1 extending horizontally, an upper outer wall b2 protruding upward from an edge region of the upper surface of the plate 121 to form the first internal space, and a lower outer wall b3 protruding downward from an edge region of the lower surface of the plate b1 to form the second internal space.

Here, the first internal space may be an area surrounded by the first window 30, the plate b1, and the upper outer wall b2. The second internal space may be an area surrounded by the second window 34, the plate b1, and the lower outer wall b3.

The edge region of the upper surface of the main case 31 may be in contact with the edge region of the lower surface of the first window 30. In this case, a bonding member (not shown) may be provided in at least a portion of the space between the edge region of the upper surface of the main case 31 and the edge region of the lower surface of the first window 30. The first window 30 and the main case 31 can be bonded using this bonding member.

In addition, the edge region of the lower surface of the main case 31 may be in contact with the edge region of the upper surface of the second window 34. In this case, a bonding member (not shown) may be provided in at least a portion of the space between the edge region of the lower surface of the main case 31 and the edge region of the lower surface of the second window 34. The second window 34 and the main case 31 can be bonded using this bonding member.

Referring to FIG. 9 and FIG. 10, the main case 31 may include an insertion hole h1 formed on the side and a battery fastening recess f1 extending from the insertion hole h1 into the interior of the main case 31. The battery 37 may be inserted into the insertion hole h1 and positioned within the battery fastening recess f1.

The battery 37 may have a shape that allows the battery 37 to be accommodated in the battery fastening recess f1 formed to extend into the interior of the main case 31. For example, the battery 37 may have a rod structure extending in one direction, and the rod structure of the battery 37 may have a shape corresponding to the internal space of the battery fastening recess f1. The volume of the battery 37 may be smaller than the internal space of the battery fastening recess f1.

The side surface of the battery 37 may have a curved shape. For example, the entire side surface of the battery 37 may have a structure in which curved shapes are continuously connected.

Battery fixing portions 44 and 45 for fixing the battery 37 may be formed within the battery fastening recess f1. For example, the battery fixing portions 44 and 45 may have a curved shape corresponding to the curved shape of the side surface of the battery 37. In this case, the battery fixing portions 44 and 45 may include a first protruding curved portion 44 that contacts the left side surface of the battery 37 and a second protruding curved portion 45 that contacts the right side surface of the battery 37.

The first protruding curved portion 44 and the second protruding curved portion 45 may be provided to face each other on the inner surface of the main case 31 within the battery fastening recess f1. The first protruding curved portion 44 and the second protruding curved portion 45 may be spaced apart by a distance similar to the width of the battery 37.

The first protruding curved portion 44 and the second protruding curved portion 45 may have predetermined elasticity. The battery 37 may be inserted between the first protruding curved portion 44 and the second protruding curved portion 45, and the battery 37 can be fixed by the elasticity of the first protruding curved portion 44 and the second protruding curved portion 45.

Referring to FIG. 10, the end of the battery fastening recess f1 opposite the insertion hole h1 may have a sub-battery fastening recess f2 having a shape corresponding to an end of the battery 37. For example, the end of the battery 37 may have a round shape, and the end of the battery fastening recess f1 opposite the insertion hole h1 may have a rounded concave sub-battery fastening recess f2 that can accommodate the round shape of the end of the battery 37.

A connecting hole h2 connecting the first internal space and the second internal space may be formed in the main case 31. The electronic shelf label 100 may include a connector 43 that connects the first printed circuit board 33 and the second printed circuit board 36. Data transmission and reception between the first printed circuit board 33 and the second printed circuit board 36 can occur through the connector 43.

The connector 43 may be formed in the main case 31 and may connect the first printed circuit board 33 and the second printed circuit board 36 through the connecting hole h2 connecting the first internal space and the second internal space.

In addition, an insertion hole into which the button 1 can be inserted may be formed in a portion of the side surface of the main case 31. For example, the button 1 may be inserted into the insertion hole formed in a portion of the side surface of the main case 31, and the button 1 may be connected to the first printed circuit board 33. Specifically, the button 1 may be connected to a button input receiver of the first printed circuit board 33 through the insertion hole.

Referring to FIG. 9, fastening members 50, 51, 52, and 53 formed to be coupled to external fixing members may be provided on the outer side surface of the main case 31. Specifically, one or more fixing recesses may be formed at portions of the lower side of the outer surface of the main case 31, and the fastening members 50, 51, 52, and 53 formed to be coupled with external fixing members may be provided in the fixing recesses.

For example, a first fixing recess and a second fixing recess may be formed at the lower side of the outer surface of the main case 31, a first fastening member 50 may be provided in the first fastening recess, and a second fastening member 51 may be provided in the second fastening recess.

Furthermore, a third fixing recess and a fourth fixing recess may be formed at the side of the outer surface of the electronic shelf label 100, a third fastening member 52 may be provided in the third fastening recess, and a fourth fastening member 53 may be provided in the fourth fastening recess. Here, each of the plurality of fastening members 50, 51, 52, and 53 may include an insert that can be fastened to a bolt-shaped fastening member.

The first display module 32 can display product-related information. For example, the first display module 32 may include an electronic paper display (EPD). E-paper displays are suitable for electronic shelf labels 100, which require reduced power consumption, due to their bistability, which allows the displays to maintain their display state for a long period of time even when power is interrupted.

Known types of e-paper displays include a twist ball type using electrostatically charged hemispherical twist balls, an electrophoretic display utilizing electrophoresis and microcapsules, and a cholesterol liquid crystal display using cholesterol liquid crystals.

However, the present disclosure is not limited thereto, and the display module 32 may include any one of a liquid crystal display (LCD), a thin film transistor-liquid crystal display (TFT LCD), an organic light-emitting diode (OLED), a flexible display, and a 3D display.

The first printed circuit board 33 is electrically connected to the first display module 32 and may operate the first display module 32. The first printed circuit board 33 may be positioned on the rear surface of the first display module 32. The first printed circuit board 33 positioned on the rear surface of the first display module 32 may serve to support the first display module 32.

One or more electronic components for operating the electronic shelf label 100 may be mounted on the front or rear surface of the first printed circuit board 33. For example, a main chip including a processor that controls the operation of the electronic shelf label 100 may be mounted on the first printed circuit board 33. The first printed circuit board 33 may be formed in a plate shape. The first printed circuit board 33 may receive power from the battery 37 disposed inside the main case 31.

The second window 34 may have a flat shape including a front surface and a rear surface. The second window 34 may externally expose product-related information displayed by the second display module 35 through the rear surface. Specifically, the second window 34 may be formed of a glass material and may transmit image information output from the second display module 35.

The second window 34 may cover the entire rear surface of the second display module 35. For example, the area of the rear surface of the second window 34 may be larger than the area of the front surface of the second display module 35. Furthermore, for example, the shape and size of the second display area DA2 in FIG. 3 may correspond to the shape and size of the area where image information of the second display module 35 is output.

The second printed circuit board 36 may be electrically connected to the second display module 35 and may operate the second display module 35. The second printed circuit board 36 may be placed on the front surface of the second display module 35. The second printed circuit board 36 placed on the front surface of the second display module 35 may serve to support the second display module 35.

One or more electronic components for receiving data and signals from the first printed circuit board 33 and operating the electronic shelf label 100 may be mounted on the front or rear surface of the second printed circuit board 36. The second printed circuit board 36 may be formed in a plate shape. The second printed circuit board 36 may receive power from the battery 37 disposed inside the main case 31.

The battery 37 can provide power necessary to operate the first display module 32, the first printed circuit board 33, the second display module 35, and the second printed circuit board 36.

The battery 37 may be inserted into the center of the main case 31. Specifically, the battery 37 may be inserted into the battery fastening recess f1 of the main case 31. The battery 37 inserted into the battery fastening recess f1 may be fixed by being coupled to the battery fixing portions 44 and 45 provided within the battery fastening recess f1.

Referring to FIG. 7, a lead wire 40 that can be electrically connected to the first printed circuit board 33 may be formed on the battery 37. For example, a terminal 41 protruding from the first printed circuit board 33 may be connected to the lead wire 40 of the battery 37. In this way, power for operating the first display module 32, the first printed circuit board 33, the second display module 35, and the second printed circuit board 36 can be supplied from the battery 37 by the connection of the terminal 41 and the lead wire 40.

For example, the battery 37 may include a battery having a rod-shaped structure extending in one direction. The rod-shaped structure of the battery 37 may have a shape corresponding to the internal space of the battery fastening recess f1. However, the present disclosure is not limited thereto, and the battery 37 may include various types of batteries, such as a coin-shaped battery.

The battery 37 may be inserted into the insertion hole h1 formed at the side surface of the main case 31, and when the battery 37 is disposed in the battery fastening recess f1 inside the insertion hole h1, a battery cover 42 can cover the insertion hole h1. The battery cover 42 may be formed in a structure that can be fitted/removed in/from the insertion hole h1, and a user can open the battery cover 42 and separate the battery 37 from the battery fastening recess f1.

Referring back to FIG. 7, the electronic shelf label 100 may further include a first reinforcing plate 38 provided between the first display module 32 and the first printed circuit board, and a second reinforcing plate 39 provided between the second display module 35 and the second printed circuit board 36.

The first reinforcing plate 38 may support the first display module 32, thereby preventing the first display module 32 from being bent or deformed due to stress. In addition, the second reinforcing plate 39 may support the second display module 35, thereby preventing the second display module 35 from being bent or deformed due to stress.

In this case, the area of the first reinforcing plate 38 may be larger than the area of the first display module 32, and the area of the second reinforcing plate 39 may be larger than the area of the second display module 35. However, the present disclosure is not limited thereto, and the area of the first reinforcing plate 38 may be smaller than or equal to the area of the first display module 32, and the area of the second reinforcing plate 39 may be smaller than or equal to the area of the second display module 35.

The first reinforcing plate 38 and the second reinforcing plate 39 may include metal plates. However, the present disclosure is not limited thereto, and the first reinforcing plate 38 and the second reinforcing plate 39 may be formed of various materials other than metal.

Meanwhile, referring to FIG. 11, a battery fixing portion 46 according to another embodiment may include a clamp-shaped curved portion provided at a position facing the insertion hole h1 within the fastening recess f1.

For example, the clamp shape of the battery fixing portion 46 may have a structure that wraps around the end of the battery 37 and presses both sides of the end of the battery 37. By pressing the sides of the battery 37 by the clamp shape of the battery fixing portion 46, the battery 37 can be fixed to the battery fixing portion 46.

Referring to FIG. 12 and FIG. 13, the electronic shelf label 100 may be connected to external strings s1, s2, s3, and s4. The strings s1, s2, s3, and s4 may be connected to the electronic shelf label 100 while suspended from an external installation structure, thereby allowing the electronic shelf label 100 to be suspended from the installation structure.

Referring to FIG. 14, hanging holes h3 and h4 formed at the corners of the main case 31 to be coupled to the external strings s1, s2, s3, and s4 may be provided.

### - Method S100 of Operating Electronic Shelf Label

Hereinafter, methods S100 and S200 of operating the electronic shelf label 100 according to various embodiments will be described in detail with reference to FIG. 15. In describing the method with reference to FIG. 15, reference will be made to the symbols of components included in the electronic shelf label 100 shown in FIG. 1 to FIG. 14.

FIG. 15 is a flowchart of method S100 of operating the electronic shelf label according to an embodiment.

Referring to FIG. 15, the method S100 of operating the electronic shelf label may include step S101 of receiving a first user input, step S103 of operating the first display module 32 according to the first user input, step S105 of receiving a second user input, and step S107 of operating the second display module 35 according to the second user input.

In step S101, the processor included in the main chip mounted on the first printed circuit board 33 may receive the first user input from an external user. The first user input may be a user input applied to the first computing device 300 by a first user. The first user input data may be transmitted from the first computing device 300 to the processor included in the main chip mounted on the first printed circuit board 33.

In step S103, the processor included in the first printed circuit board 33 may control the operation of the first display module 32 connected to the first printed circuit board 33 upon receiving the first user input. For example, the processor may control the first display module 32 to display first product-related information in response to the first user input.

In step S105, the processor included in the main chip mounted on the first printed circuit board 33 may receive a second user input from an external user. The first printed circuit board 33 may transmit the second user input data to the second printed circuit board 36.

The second user input may be a user input applied to the first computing device 300 by the first user. In this case, the second user input may be different from the first user input.

For example, the first user input may be an input for displaying information related to a first product, located on the left side of the front of the electronic shelf label 100, on the first display module 32, and the second user input may be an input for displaying information related to a second product, located on the right side of the front of the electronic shelf label 100, on the second display module 35.

The second user input data may be transmitted from the first computing device 300 to the processor included in the main chip mounted on the first printed circuit board 33. As such, the first user input and the second user input may be inputs from the same first user.

However, the present disclosure is not limited thereto, and the first user input and the second user input may be inputs from different users. For example, the second user input may be a user input applied to the second computing device 400 by a second user different from the first user.

In step S107, as the second user input data received by the processor included in the first printed circuit board 33 is transmitted to the second printed circuit board 36, the operation of the second display module 35 can be controlled by the second printed circuit board 36.

In this way, the first display module 32 is controlled by the first user input, and the second display module 35 is controlled by the second user input, and thus the first display module 32 and the second display module 35 can be controlled by different user inputs.

Meanwhile, when the first user input for operating the first display module 32 by the first user is received, reception of a user input for operating the first display module 32 by the second user different from the first user can be blocked. Accordingly, two or more users can be prevented from simultaneously transmitting user inputs to the first display module 32.

In addition, when the second user input for operating the second display module 35 by the second user is received, reception of a user input for operating the second display module 35 by the first user different from the second user can be blocked. Accordingly, two or more users can be prevented from simultaneously transmitting user inputs to the second display module 35.

In this way, by preventing two or more users from simultaneously transmitting user inputs to the first display module 32 or the second display module 35, the first display module 32 and the second display module 35 can be independently controlled by different users.

The specific implementations described herein are exemplary embodiments and do not limit the scope of the present disclosure in any way. For the sake of brevity, descriptions of conventional electronic components, control systems, software, and other functional aspects of the systems may be omitted. Furthermore, the lines or connecting elements between components depicted in the drawings are merely illustrative of functional connections and/or physical or circuit connections. In actual devices, these connections may be replaced or represented as various additional functional, physical, or circuit connections. Furthermore, unless specifically stated as "essential," "important," or the like, a component may not be absolutely necessary for the application of the present disclosure.

Although the detailed description of the present disclosure has been made with reference to preferred embodiments of the present disclosure, it will be understood by those skilled in the art or those with ordinary knowledge in the art that various modifications and variations can be made to the present disclosure without departing from the spirit and scope of the present disclosure as set forth in the claims. Therefore, the technical scope of the present disclosure should not be limited to the details set forth in the detailed description of the specification, but should be defined by the scope of the claims.

### [Industrial Applicability]

The present disclosure has industrial applicability in that it can provide product-related information to users in a more diverse manner by utilizing a double-sided electronic shelf label having improved durability and a slim design, and can maximize the usability of the electronic shelf label by independently controlling the operation of a front display and the operation of a rear display included in the double-sided electronic shelf label, thereby increasing the convenience of customers using stores.

## Claims

1. An electronic shelf label comprising:
a first window;
a main case coupled to a rear surface of the first window;
a first display module provided in a first internal space formed between the first window and the main case to display product information;
a first printed circuit board provided in the first internal space and electrically connected to the first display module;
a second window coupled to a rear surface of the main case;
a second display module provided in a second internal space formed between the second window and the main case to display product information;
a second printed circuit board provided in the second internal space and electrically connected to the second display module; and
a battery provided to be inserted into the main case.

2. The electronic shelf label of claim 1, wherein the main case comprises an insertion hole formed in a side surface and a battery fastening recess extending from the insertion hole into the interior of the main case,
wherein the battery is inserted into the insertion hole and provided within the battery fastening recess.

3. The electronic shelf label of claim 2, wherein a battery fixing portion for fixing the battery is formed within the battery fastening recess.

4. The electronic shelf label of claim 3, wherein the side surface of the battery has a curved shape, and the battery fixing portion has a curved shape corresponding to the curved shape of the side surface of the battery.

5. The electronic shelf label of claim 4, wherein the battery fixing portion comprises a first protruding curved portion that contacts the left side of the battery and a second protruding curved portion that contacts the right side of the battery.

6. The electronic shelf label of claim 4, wherein the battery fixing portion comprises a clamp-shaped curved portion provided at a position facing the insertion hole within the battery fastening recess.

7. The electronic shelf label of claim 1, wherein the main case comprises:
a plate extending horizontally;
an upper outer wall protruding upward from an edge region of the upper surface of the plate to form the first internal space; and
a lower outer wall protruding downward from an edge region of the lower surface of the plate to form the second internal space.

8. The electronic shelf label of claim 1, wherein a connecting hole is formed in the main case to connect the first internal space and the second internal space.

9. The electronic shelf label of claim 1, further comprising a connector connecting the first printed circuit board and the second printed circuit board.

10. The electronic shelf label of claim 9, wherein the connector is formed in the main case and connects the first printed circuit board and the second printed circuit board through the connecting hole connecting the first internal space and the second internal space.

11. The electronic shelf label of claim 1, further comprising:
a first reinforcing plate provided between the first display module and the first printed circuit board; and
a second reinforcing plate provided between the second display module and the second printed circuit board.

12. A method of operating an electronic shelf label comprising a first display module exposed on the front, a first printed circuit board electrically connected to the first display module, a second display module exposed on the rear, and a second printed circuit board electrically connected to the second display module, the method comprising:
receiving a first user input;
operating the first display module according to the first user input;
receiving a second user input; and
operating the second display module according to the second user input.

13. The method of operating an electronic shelf label of claim 12, wherein the first user input and the second user input are inputs from the same first user, and the first user input and the second user input are different from each other.

14. The method of operating an electronic shelf label of claim 12, wherein the first user input is input from a first user, and the second user input is input from a second user different from the first user.

15. The method of operating an electronic shelf label of claim 14, wherein reception of user input for operating the first display module from the second user is blocked when the first user input for operating the first display module from the first user is received, and reception of user input for operating the second display module from the first user is blocked when the second user input for operating the second display module from the second user is received.
